# EUROPEAN PATENT APPLICATION

(11) **EP 1 107 335 A2**
(43) Date of publication of application: **13.06.2001**
(21) Application number: 00309143.6
(22) Date of filing: 17.10.2000
(51) Int. Cl.: H01L 51/20

(54) **Organic EL display device**

(30) Priority: 30.11.1999 JP 33993699
(71) Applicant: TDK Corporation, Tokyo 103-8272 (JP)
(72) Inventor: Tanabe, Hiroshi, TDK Corporation, Tokyo 103-8272 (JP); Ishiguru, Shigeyuki, TDK Corporation, Tokyo 103-8272 (JP)
(74) Representative: Wise, Stephen James

(57) **Abstract**

The present invention provides an organic EL display device comprising a pair of electrodes and at least one organic layer interposed between the electrodes. At least one of the electrodes comprises an indium oxide-containing transparent electrode at a site corresponding to a light emitting area. A metal electrode is provided at a site other than the site corresponding to the light emitting area, where the metal electrode is connected to the transparent electrode. The metal electrode contains as a main component Ag, Cu or Ag-Cu and as a subordinate component one or two or more metal elements selected from the group consisting of at least Rh, Pd, In, Pt and Au.

## Description

### BACKGROUND OF THE INVENTION

The present invention relates generally to an organic EL display device using an organic compound, and specifically to an improvement in or relating to an electrode for injecting holes in a light emitting layer.

In recent years, organic EL devices have been under intensive investigation. One such device is basically built up of a thin film form of hole transporting material such as TPD deposited by evaporation on a hole injecting electrode, a light emitting layer of fluorescent material such as Alq3 laminated thereon, and a metal (electron injecting) electrode of a metal having a low work function such as Mg and formed on the light emitting layer. This organic EL device now attracts attentions because a very high luminance ranging from several hundreds to tens of thousands cd/m² can be achieved with a voltage of approximately 10 V.

One requirement for the material for the hole injecting electrode in such an organic EL device is that it be transparent and electrically conductive because the organic EL device is usually designed to extract the emitted light from a substrate side thereof. ITO, IZO, ZnO, SnO₂, In₂O₃, etc. have been known for such transparent electrodes. Among these, ITO electrodes have a visible light transmittance of 80% or greater and a sheet resistance of 10 Ω/□ or less, and so find wide applications as transparent electrodes for LCDs, solar batteries and so on. The ITO electrodes are also considered to be promising for hole injecting electrodes in the organic EL devices.

An organic EL device requires a given current for light emission, and the light emission luminance increases in proportion to an applied current density. Consequently, when sophisticated display patterns or large-screen displays are driven with high luminance or at high duty ratios, the resistance of interconnecting lines in the hole injecting electrode is found to give rise to voltage drop problems in conjunction with transparent electrodes such as hole injecting electrodes or electrode structures joined thereto, although this resistance is negligible when the length of interconnecting lines is short.

It is known that the dependency of the spectra of extracted light on the angle of view increases with an increasing thickness of the device from a light emitting layer to a transparent electrode. It is thus difficult to solve the voltage drop problem by increasing the thickness of the transparent electrode to form a hole injecting electrode of low sheet resistance.

For means for providing a solution to these problems, JP-A's 10-162961, 10-199680, 10-214684, 10-223374, 11-31590, 11-144877, etc. have proposed to locate a metal electrode contiguous to the transparent electrode. According to these proposals, Ni, Cu, Cr, Ti, Fe, Co, Au, Ag, Al, Pt, Rh, Pd and Sn as well as their alloys may be used for such a metal electrode. However, these materials are found to have their own problems; for instance, Al offers a connecting or hillock problem in conjunction with ITO, Ni, Cr, Fe, Co, Pt and Pd present a problem when they are used in the form of low-resistance interconnecting material thanks to their high resistivity, Cu and Ag have a corrosion problem, and Au, Pt, Rh and Pd have a cost problem.

Especially when Al is used, it is required to provide a buffer layer to prevent battery reactions which may otherwise occur in a resist remover solution upon its contact with an ITO transparent electrode (a Cr buffer layer is referred to in JP-A 10-199680; Cr, Ti, and Ti-N buffer layers in JP-A 11-31590, and Mo, and Ni buffer layers in JP-A 11-144877). This leads to an additional cost problem due to an increase in the number of photomasks used for patterning, an increase in the processing time, etc. Hillocks, if they occur in an Al layer, give rise to an insulation drop problem.

For means for solving the hillock problem and the battery reaction problem with ITO which are found in the case of Al electrodes, Al alloy electrodes wherein metals such as Si, Cu, Ti, Ta, Mo, Cr, Ni, Y, La, Nd, Gd, Tb, Dy and W are added to Al are put forward in JP-A's 10-275683, 11-144877, etc. Owing to the influence of the added metals, however, such Al alloy electrodes have too high resistivity to be used in the form of low-resistance conductive films.

On the other hand, JP-A 5-100248 proposes to use a interconnecting material with Ta, Ti and Zr added to Al. However, a thermal treatment at 250 to 500^{.}C must be carried out to lower the resistance of the material. It is thus difficult to apply this material to a structure wherein an underlying organic layer comprising a color filter, a color conversion film, a flattening film and so on is provided beneath a transparent electrode.

As mentioned above, never until now is any material achieved, which material can satisfy all requirements for prevention of hillocks and battery reactions with ITO, the decrease in the number of photomasks due to a direct junction with ITO, the resolution of the voltage drop problem due to the achievement of low resistance, a low-cost material, etc.

### SUMMARY OF THE INVENTION

A primary object of the present invention is to achieve a high-quality yet low-cost organic EL display device by lowering the wiring resistance of a transparent electrode, improving the dependence of extracted spectra on the angle of field, stabilizing a fabrication process due to prevention of hillocks, and dispensing with any barrier metal layer, thereby achieving considerable cost reductions.

The aforesaid object is achieved by the inventions defined below as (1) to (7).
(1) An organic EL display device comprising a pair of electrodes and at least one organic layer interposed between the electrodes, wherein:
   at least one of said electrodes comprises an indium oxide-containing transparent electrode at a site corresponding to a light emitting area, and
   a metal electrode is provided at a site other than said site corresponding to said light emitting area, where said metal electrode is connected to said transparent electrode,
   said metal electrode containing as a main component Ag, Cu or Ag-Cu and as a subordinate component one or two or more metal elements selected from the group consisting of at least Rh, Pd, In, Pt and Au.
(2) The organic EL display device according to (1) above, wherein said transparent electrode is directly connected to said metal electrode.
(3) The organic EL display device according to (1) or (2) above, wherein said subordinate component accounts for 0.1 to 5% by weight of all components.
(4) The organic EL display device according to any one of (1) to (3) above, wherein said transparent electrode has a film thickness of 100 nm or less.
(5) The organic EL display device according to any one of (1) to (4) above, wherein said metal electrode further contains one or two or more metal elements selected from the group consisting of Ti, V, Cr, Mn, Fe, Co, Ni, Nb, Mo, Ta and W in an amount of 0.1 to 5% by weight with respect to all components.
(6) The organic EL display device according to any one of (1) to (5) above, wherein said main component is an alloy comprising Ag and Cu as primary ingredients.
(7) The organic EL display device according to any one of (1) to (6) above, wherein said main component is an alloy comprising Ag and Cu as primary ingredients with the content of Cu in said main component being 0.1 to 5% by weight with respect to all ingredients, and
   said main component contains as an additional subordinate component Pd in an amount of 0.1 to 5% by weight to all components.

### BRIEF DESCRIPTION OF THE DRAWINGS

The above and other objects, features, and advantages of the invention will be better understood from the following description taken in conjunction with the accompanying drawings.

Fig. 1 is a plan view of the first embodiment of the present invention, wherein the relations between the metal electrode and the pixels (ITO) are illustrated.

Fig. 2 is a sectional view of Fig. 1 as taken along the A-A' line.

Fig. 3 is a plan view of the second embodiment of the present invention, wherein the relations between the metal electrode and the pixels (ITO) are illustrated.

Fig. 4 is a sectional view of Fig. 3 as taken along the A-A' line.

Fig. 5 is a plan view of the third embodiment of the present invention, wherein the relations between the metal electrode and the pixels (ITO) are illustrated.

Fig. 6 is a sectional view of Fig. 5 as taken along the A-A' line.

Fig. 7 is a plan view of the fourth embodiment of the present invention, wherein the relations between the metal electrode and the pixels (ITO) are illustrated.

Fig. 8 is a sectional view of Fig. 7 as taken along the A-A' line.

### DETAILED DESCRIPTION OF THE INVENTION

According to the present invention, there is provided an organic EL display device comprising a pair of electrodes and at least one organic layer interposed between the electrodes, wherein:
at least one of said electrodes comprises an indium oxide-containing transparent electrode at a site corresponding to a light emitting area, and
a metal electrode is provided at a site other than said site corresponding to said light emitting area, where said metal electrode is connected to said transparent electrode,
said metal electrode being formed of an alloy containing Ag and/or Cu, which alloy contains at least one metal element selected from the group consisting of at least Rh, Pd, In, Pt and Au.

By joining such a metal electrode directly to the transparent electrode to form a hole injecting electrode, it is possible to keep the whole resistance value of the hole injecting electrode low and, at the same time, dispense with a barrier metal layer that should be located between the transparent electrode and a conventional Al electrode, so that the fabrication process can be simplified with a decrease in the number of masks and fabrication cost reductions. It is further possible to achieve a process substantially free of hillocks that are a grave problem with the conventional Al electrode.

It is also possible to dispense with any thermal treatment process to reduce the resistance of the metal electrode and, hence, to make use of an underlying organic layer comprising a color filter, a color conversion film, a flattening film and so on.

The transparent electrode is formed and located at least at a site corresponding to the light emitting area (pixel area), and connected to the metal electrode at a junction. By the term "light emitting area" used herein is intended an area at which a light emitting layer can give out light, and out of which the emitted light can be taken for use. Likewise, by the "junction with the metal electrode" is intended an electrical junction of the transparent electrode with the metal electrode located at the site other than the light emitting area. The area where the metal electrode is located is limited by the design of an organic EL display comprising a plurality of organic EL devices; that is, the shorter the pitch between adjacent pixels, the narrower the area with the metal electrode located thereon becomes. To ensure the necessary sheet resistance, it is then required to optimize the resistivity and film thickness of the metal electrode. The transparent electrode area may be defined by not only the site corresponding to the light emitting area and the junction with the metal electrode but also the boundary between the light emitting area and the periphery of the light emitting area. Required for the junction with the metal electrode is an area where sufficiently low connection resistance is achievable.

For the transparent electrode, it is preferable to use an electrode containing at least indium oxide, especially, ITO, IZO, ZnO, SnO, In₂O₃ or the like, with ITO and IZO being most preferred. For ITO, it is desired that the mixing ratio of SnO₂ with respect to In₂O₃ be in the range of 1 to 20 wt%, and especially 5 to 12 wt%. For IZO, the mixing ratio of ZnO with respect to In₂O₃ is preferably in the range of 1 to 20 wt%, and especially 5 to 12 wt%. Besides, ITO, and IZO may contain an oxide form of Sn, Ti, Pb, etc. in an amount of up to 1% by weight as calculated on an oxide basis.

Such a transparent electrode is usually used as an anode or hole injecting electrode.

The transparent electrode may have at least a certain thickness enough to inject charges such as holes, and is usually in the range of 10 to 100 nm. However, a thickness of 30 to 100 nm, and especially 50 to 90 nm is preferred. At a film thickness of 100 nm or less, the transparent electrode has so low surface roughness that its surface properties can be improved, resulting in improvements in light emission properties, light emission life, etc. Too small a thickness offers problems in conjunction with film thickness upon film formation, and the ability of the electrode to transport holes. Too large a thickness makes the dependence of extracted light spectra on the angle of view likely to increase. According to the present invention, however, it is unnecessary to increase the thickness of the transparent electrode, thereby lowering its sheet resistance, because the hole injecting electrode is formed of both the transparent electrode and the metal electrode.

The transparent electrode should preferably have a light transmittance of 50% or greater, especially 80% or greater, and more especially 90% or greater with respect to light usually in the wavelength range of 400 to 700 nm, and especially with respect to emitted light. At too low a transmittance, the light emitted from the light emitting layer attenuates; it is difficult to obtain the luminance needed for a light emitting device.

The metal electrode (interconnecting electrode) has a sheet resistance of preferably 1 Ω/□ or less, and especially 0.5 Ω/□ or less. Although there is no lower limit to sheet resistance, a sheet resistance of about 0.1 Ω/□ is generally preferred. Preferably, the metal electrode has a thickness of the order of preferably 10 to 2,000 nm, especially 20 to 1,000 nm, and more especially 100 to 500 nm.

The metal electrode is formed of an alloy containing as the main component Ag, Cu or Ag-Cu and as the first subordinate component one or two or more metal elements selected from the group consisting of Pd, In, Pt and Au. It is preferable that the alloy contains both Ag and Cu as the main components. In this case, Cu should account for preferably 0.1 to 5% by weight, more preferably 0.3 to 3% by weight, and even more preferably 0.5 to 2.0% by weight of all components. By the proper addition of Cu to Ag improvements in corrosion resistance are achievable. However, too little Cu makes its effect slender and too much causes element segregation.

The total amount of the metal elements Rh, Pd, In, Pt and Au added as the first subordinate component should be preferably 0.1 to 5% by weight, more preferably 0.3 to 3.0% by weight, and even more preferably 0.5 to 2.0% by weight with respect to all components. Too little subordinate components result in a corrosion resistance drop whereas too much causes element segregation.

The metal electrode according to the present invention may contain as the second subordinate component one or two or more metal elements selected from the group consisting of Ti, V, Cr, Mn, Fe, Co, Ni, Nb, Mo, Ta and W. In this case, the total amount of these metal elements should be preferably 0.1 to 5% by weight, more preferably 0.3 to 3.0% by weight, and even more preferably 0.5 to 2.0% by weight with respect to all components. By the addition of these metal elements in proper amounts, improvements in corrosion resistance are achievable. However, too little elements make their effects slender whereas too much causes element segregation.

It is acceptable to connect the metal electrode according to the present invention to the transparent electrode with a barrier metal layer interposed between them. In the practice of the invention, however, it is preferable to join the metal electrode directly to the transparent electrode. At the junction, the transparent and metal electrode are joined to each other usually with a metal such as Cr or Ti or a nitride such as Ti-N, each acting as a barrier metal, interposed between them. This is to prevent electro-chemical corrosion from occurring between the indium oxide-containing transparent electrode and the metal electrode. According to the invention that can prevent any electro-chemical corrosion between the indium oxide-containing transparent electrode and the metal electrode, however, it is possible to make a direct connection between both the electrodes. By joining both the electrodes directly to each other without recourse to any barrier metal layer, it is possible to reduce the number of steps for film formation and patterning and dispense with photomasking, thereby achieving significant cost reductions.

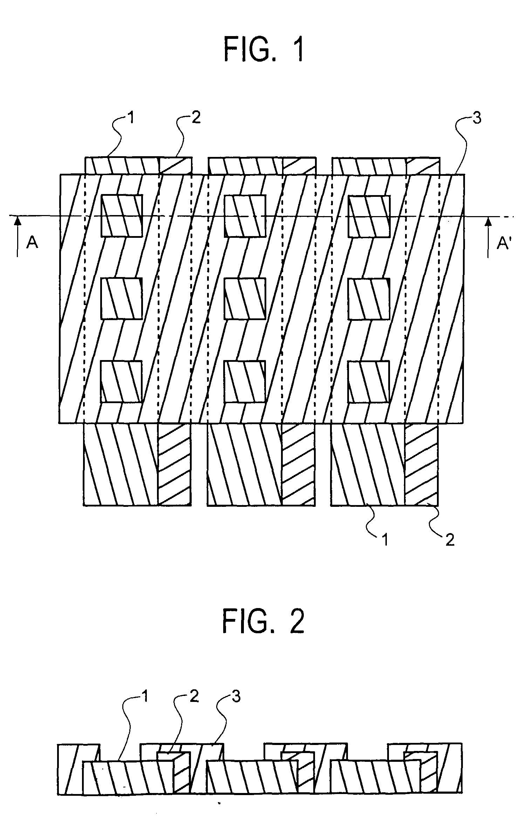

Specific embodiments of the metal electrode of the present invention and the light emitting area of the transparent electrode that provides pixels are shown in Figs. 1 to 8.

Fig. 1 is illustrative of one embodiment of the present invention. More specifically, Fig. 1 is a plan view of how the metal electrode is actually positioned with respect to the light emitting area of the transparent electrode that provides pixels, and Fig. 2 is a sectional view of Fig. 1 as taken along the A-A' line.

Referring to Figs. 1 and 2, a metal electrode 2 is formed and positioned laterally of an ITO pattern 1 that is the transparent electrode, and an insulating layer 3 is provided in such a way as to cover these parts. The insulating layer 3 has an opening in an ITO area defining a pixel area. On an ITO area under the opening there is formed an organic EL structure such as an organic layer.

By selective use of a metal material that can be brought in direct contact with the ITO 1, it is thus possible to dispose the metal electrode 2 along the ITO 1. It is here noted that the area where the ITO 1 is in contact with the metal electrode 2 defines a junction.

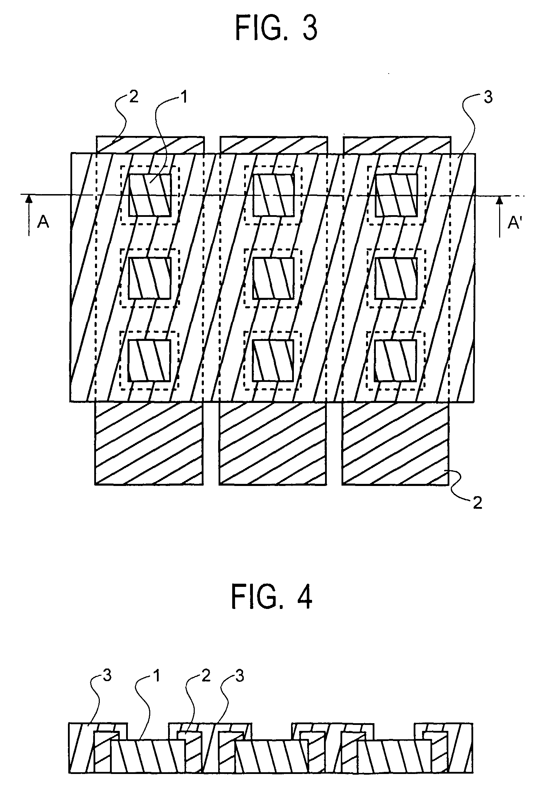

Fig. 3 is illustrative of another embodiment of the present invention. More specifically, Fig. 3 is a plan view of how the metal electrode is actually positioned with respect to the light emitting area of the transparent electrode that provides pixels, and Fig. 4 is a sectional view of Fig. 3 as taken along the A-A' line.

Referring to Figs. 3 and 4, a metal electrode 2 is formed and positioned in such a way as to cover an ITO pattern 1 that is the transparent electrode, and provided with an opening at a pixel-defining site. Then, an insulating layer 3 is formed in such a way as to cover these parts. In an ITO site defining the pixel area, the insulating layer 3 has an opening slightly smaller than the metal electrode 2. On an ITO area under the opening there is formed an organic EL structure such as an organic layer.

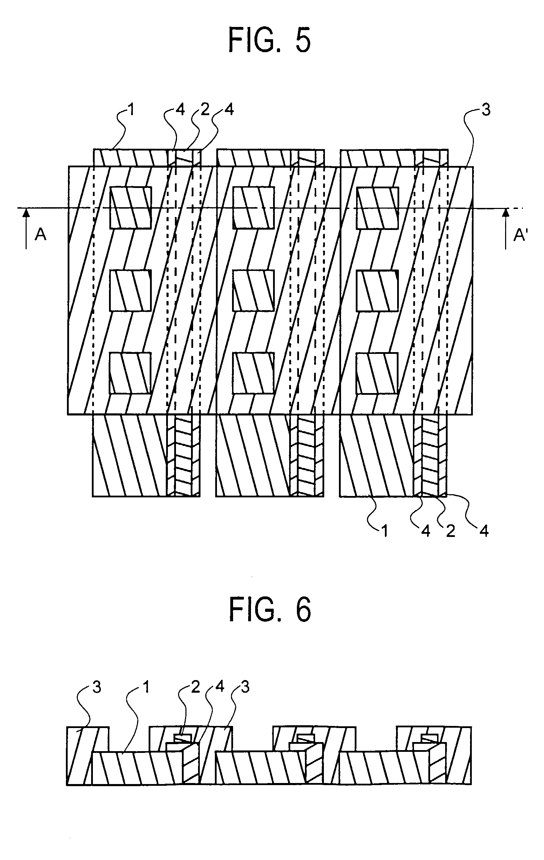

Fig. 5 is illustrative of the third embodiment of the present invention. More specifically, Fig. 5 is a plan view of how the metal electrode is actually positioned with respect to the light emitting area of the transparent electrode that provides pixels, and Fig. 6 is a sectional view of Fig. 5 as taken along the A-A' line. In this embodiment, an ITO 1 is connected to a metal electrode 2 with a barrier metal layer 4 interposed between them.

Referring to Figs. 5 and 6, the barrier metal layer 4 is formed and positioned laterally of the ITO pattern 1 that is the transparent electrode in such a way as to come in contact with the ITO 1, and an insulating layer 3 is provided in such a way as to cover the barrier layer 3. The insulating layer 3 has an opening in an ITO area defining a pixel area. On an ITO area under the opening there is formed an organic EL structure such as an organic layer.

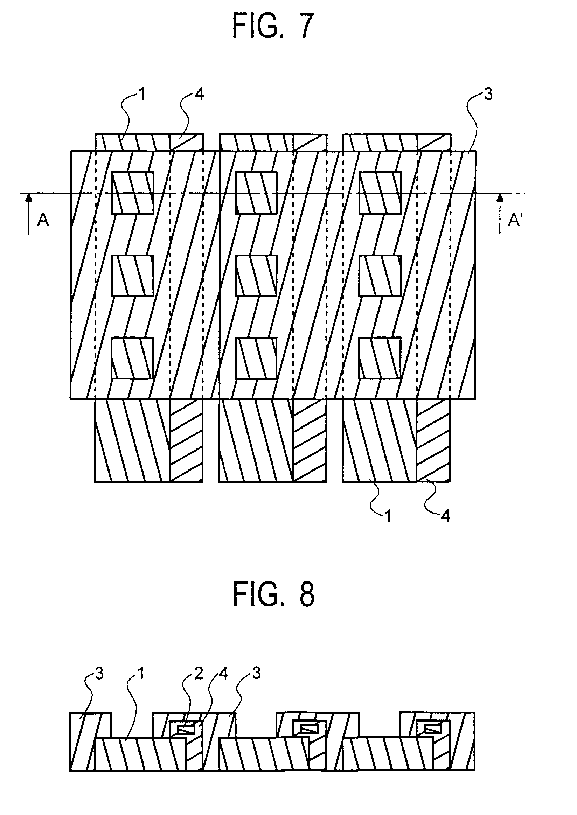

Fig. 7 is illustrative of the fourth embodiment of the present invention. More specifically, Fig. 7 is a plan view of how the metal electrode is actually positioned with respect to the light emitting area of the transparent electrode that provides pixels, and Fig. 8 is a sectional view of Fig. 7 as taken along the A-A' line. In this embodiment, an ITO 1 is connected to a metal electrode 2 with a barrier metal layer 4 interposed between them.

Referring to Figs. 7 and 8, the barrier metal layer 4 is formed and positioned laterally of the ITO pattern 1 that is the transparent electrode in such a way as to come in contact with the ITO 1, and the metal electrode 2 is formed and positioned in such a way that it is embedded in the barrier metal layer 4. An insulating layer 3 is then provided in such a way as to cover these parts. The insulating layer 3 has an opening in an ITO area defining a pixel area. On an ITO area under the opening there is formed an organic EL structure such as an organic layer.

The cathode or electron injecting electrode corresponding to the transparent electrode of the present invention should preferably be made up of a metal, alloy or intermetallic compound having a work function of 4 eV or less. A material having a work function exceeding 4 eV results in a drop of electron injection efficiency and, hence, a drop of light emission efficiency. For the metal that constitutes an electron injecting electrode film having a work function of 4 eV or less, for instance, use may be made of alkaline metals such as Li, Na and K, alkaline earth metals such as Li, Mg, Ca, Sr and Ba, rare earth metals such as La and Ce, Al, In, Ag, Sn, Zn and Zr. For the alloy that constitutes an electron injecting electrode containing a metal having a work function of 4 eV or less, for instance, use may be made of Ag·Mg (Ag: 1 to 20 at%), Al·Li (Li: 0.5 to 12 at%), In·Mg (Mg: 50 to 80 at%) and Al·Ca (Ca: 5 to 20 at%). These may be used alone or in combination of two or more at any desired mixing ratio.

The electron injecting electrode may be formed by an evarporation process or the like. To form the electron injecting electrode, however, it is preferable to use sputtering processes in general, and a DC sputtering process in particular. Power for operating a DC sputtering system is in the range of preferably 0.1 to 10 W/cm², and especially 0.5 to 7 W/cm². The film deposition rate is preferably in the range of 0.1 to 100 nm/min., and especially 1 to 30 nm/min.

Preferably but not exclusively, inert gases such as Ar, He, Ne, Kr and Xe or their mixtures should be used for the sputtering gas. The sputtering pressure of such sputtering gases should usually be in the range of about 0.1 to about 20 Pa.

Such an electron injecting electrode may have at least a certain thickness enough for the injection of electrons, e.g., of at least 1 nm, and preferably at least 3 nm. Thus, a film thickness of the order of 3 to 500 nm is usually preferable although there is no upper limit thereto.

The organic EL display device of the present invention may have an auxiliary electrode layer on the electron injecting electrode, i.e., on the side of the electron injecting electrode that faces away from the organic layer. This auxiliary electrode may be used when the film resistance of the electron injecting electrode is high. The auxiliary electrode may also be used, for instance, when the electron injecting electrode is barely thick enough to maintain its minimum electron injecting function. Further, if the auxiliary electrode is used as an interconnecting electrode for simple matrix, luminance variations can then be prevented with a limited voltage drop. Furthermore, if the auxiliary electrode is applied to an active matrix type display using TFT, etc., it is then possible to achieve ever-faster operation.

When the electron injecting electrode used has a sheet resistance of usually 0.2 Ω/□ or greater, and especially 0.5 Ω/□ or greater, the auxiliary electrode is needed although depending on display size and auxiliary electrode material. Usually but not exclusively, the upper limit to the sheet resistance is a few hundreds Ω/□. When the electron injecting electrode used has a thickness of usually 300 nm or less, and especially 200 nm or less, too, it is necessary to use the auxiliary electrode, although depending on display size and auxiliary electrode material.

The auxiliary electrode may have at least a certain thickness enough to make sure of electron injection efficiency and prevent penetration of moisture, oxygen or organic solvents, for instance, of at least 50 nm, preferably at least 100 nm, and especially 100 to 1,000 nm. With too thin an auxiliary electrode layer, neither are the advantages of the invention obtainable, nor is sufficient connection with terminal electrodes obtainable because the ability of the auxiliary electrode layer to cover steps becomes low. When the auxiliary electrode layer is too thick, on the other hand, the growth rate of dark spots becomes high because of an increase in the stress of the auxiliary electrode layer.

It is also possible to use the transparent electrode as the cathode.

Furthermore, the organic EL display device of the present invention may comprise an inorganic electron injecting layer between the cathode or electron injecting electrode and the organic layer. By the provision of the inorganic electron injecting electrode, it is possible to make dramatic improvements in electron injection performance.

It is here noted that while the inorganic electron injecting layer is formed of an inorganic material, yet it is usually so thin that damage to the organic layer by a ZnO transparent electrode can effectively prevented.

The inorganic electron injecting layer (inorganic electron injecting transporting layer) comprises as a main component one or two or more oxides selected from the group consisting of lithium oxide (Li₂O), rubidium oxide (Rb₂O), potassium oxide (K₂O), sodium oxide (Na₂O), cesium oxide (Cs₂O), strontium oxide (SrO), magnesium oxide (MgO) and calcium oxide (CaO). These oxides may be used alone or in combination of two or more at any desired mixing ratio. Among these, strontium oxide is most preferred. Next is magnesium oxide, calcium oxide and lithium oxide (Li₂O) in this order. Next is rubidium oxide (Rb₂O), then potassium oxide (K₂O), and finally sodium oxide (Na₂O). When these oxides are mixed together for use, it is desired that 40 mol% or greater of strontium be contained in the mixture or lithium oxide and rubidium oxide be contained in the mixture in the total amount of 40 mol% or greater, and especially 50 mol% or greater.

The inorganic electron injecting layer contains as a stabilizer silicon oxide (SiO₂) and/or germanium oxide (GeO2), which may be used alone or in a mixture form at any desired mixing ratio.

Each of the aforesaid oxides is usually found in a stoichiometric composition form. However, it is noted that the oxide may deviate slightly from this composition; it may have a non-stoichiometric composition.

The main component should account for preferably 80 to 99 mol%, and more preferably 90 to 95 mol% of all components of the inorganic electron injecting layer, as calculated on SrO, MgO, CaO, Li₂O, Rb₂O, K₂O, Na₂O, Cs₂O, SiO₂ and GeO₂ bases, and the stabilizer should account for preferably 1 to 20 mol%, and more preferably 5 to 10 mol% of all the components.

The inorganic electron injecting layer should have a film thickness of preferably 0.1 to 2 nm, and more preferably 0.3 to 0.8 nm.

The inorganic electron injecting layer should preferably comprise as the first component an oxide or oxides of
at least one alkaline metal element having a work function of 4 eV or less, especially 1 to 4 eV, and preferably selected from the group consisting of Li, Na, K, Rb, Cs and Fr, or
at least one alkaline earth metal element having a work function of 4 eV or less, especially 1 to 4 eV, and preferably selected from the group consisting of Mg, Ca and Sr, or
at least one lanthanoid element having a work function of 4 eV or less, especially 1 to 4 eV, and preferably selected from the group consisting of La and Ce. Among these oxides, lithium oxide, magnesium oxide, calcium oxide and cerium oxide are particularly preferred. These oxides may be used in a mixture form at any desired mixing ratio. It is then preferable that the mixture contains lithium oxide in an amount of 50 mol% or greater as calculated on an Li₂O basis.

Furthermore, the inorganic electron injecting layer of high resistance comprises as the second component at least one element selected from the group consisting of Zn, Sn, V, Ru, Sm and In. Preferably in this case, the content of the second component is between 0.2 mol% and 40 mol%, and especially between 1 mol% and 20 mol%. At a smaller content the electron injecting function becomes low wheres at a greater content the hole blocking function becomes low. When two or more elements are used in combination, it is again preferable that the total content of these elements come within the aforesaid range. The second component may be present either in a metal element form or in an oxide form.

By incorporating the second component having electrical conductivity (low resistance) in the first component of high resistance, the insulating substance is allowed to contain the conductive substance in the form of islands which are then believed to form hopping paths for electron injection.

While the oxide that is the first component is usually found in a stoichiometric composition form, it is understood that the oxide may deviate slightly from the stoichiometric composition; it may have a non-stoichiometric composition. The same also holds for the second component, although it is usually present in an oxide form.

The inorganic electron injecting layer of high resistance should preferably have a film thickness of the order of 0.2 to 30 nm, and especially 0.2 to 10 nm. Any deviation from this thickness range does not allow the electron injecting layer to produce its own function satisfactorily.

Next, the organic material layers provided in the organic EL structure of the present invention are explained in detail.

The light emitting layer comprises a multilayered film formed of one or two or more organic compound thin films that, at least, take part in light emitting functions.

The light emitting layer has functions of injecting holes and electrons, transporting them, and recombining holes and electrons to create excitons. For the light emitting layer, it is preferable to use a relatively electronically neutral compound, thereby providing easy yet well-balanced injection and transportation of electrons and holes.

In addition to the light emitting layer in a narrow sense, the light emitting layer may comprise layers such as a hole transporting layer of an organic material and an electron injecting and transporting layer, if required.

The hole injecting and transporting layer has functions of facilitating injection of holes from the anode or hole injecting electrode, providing stable transportation of holes and blocking electrons, and the electron injecting and transporting layer has functions of facilitating injection of electrons from the cathode or electron injecting electrode, providing stable transportation of electrons and blocking holes. These layers are effective for increasing the number of holes and electrons injected into the light emitting layer and confining holes and electrons therein for optimizing the recombination region to improve light emission efficiency.

The thickness of the light emitting layer, the hole injecting and transporting layer, and the electron injecting and transporting layer is not critical and varies with a particular formation technique although it is usually of the order of preferably 5 to 500 nm, and especially 10 to 300 nm.

The thickness of the hole injecting and transporting layers, and the electron injecting and transporting layer is equal to, or about 1/10 times to about 10 times as large as, the thickness of the light emitting layer although it depends on the design of the recombination/light emitting region. When the electron injecting and transporting layer is separated into an injecting layer and a transporting layer, it is preferable that the injecting layer is at least 1 nm thick and the transporting layer is at least 1 nm thick. The upper limit to thickness is usually about 500 nm for the injecting layer and about 500 nm for the transporting layer. The same film thickness applies when two injecting and transporting layers are provided.

In the organic EL device according to the invention, the light emitting layer contains a fluorescent material that is a compound capable of emitting light. The fluorescent material used herein, for instance, may be at least one compound selected from compounds such as those disclosed in JP-A 63-264692, e.g., quinacridone, rubrene, and styryl dyes. Use may also be made of quinoline derivatives such as metal complex dyes containing 8-quinolinol or its derivative as ligands, for instance, tris(8-quinolinolato)aluminum, tetraphenylbutadiene, anthracene, perylene, coronene, and 12-phthaloperinone derivatives. Use may further be made of phenylanthracene derivatives disclosed in JP-A 8-12600, and tetraarylethene derivatives disclosed in JP-A 8-12969.

Preferably, the fluorescent compound is used in combination with a host substance capable of emitting light by itself; that is, it is preferable that the fluorescent compound is used as a dopant. In such a case, the content of the fluorescent compound in the light emitting layer is in the range of preferably 0.01 to 10% by weight, and especially 0.1 to 5% by weight. By using the fluorescent compound in combination with the host substance, it is possible to vary the wavelength performance of light emission, thereby making light emission possible on a longer wavelength side and, hence, improving the light emission efficiency and stability of the device.

Quinolinolato complexes, and aluminum complexes containing 8-quinolinol or its derivatives as ligands are preferred for the host substance. Such aluminum complexes are typically disclosed in JP-A's 63-264692, 3-255190, 5-70733, 5-258859, 6-215874, etc.

Exemplary aluminum complexes include tris(8-quinolinolato)aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolato-lithium, tris(5-chloro-8-quinolinolato)gallium, bis(5-chloro-8-quinolinolato)calcium, 5,7-dichloro-8-quinolinolato-aluminum, tris(5,7-dibromo-8-hydroxyquinolinolato)aluminum, and poly[zinc(II)-bis(8-hydroxy-5-quinolinyl)methane].

Use may also be made of aluminum complexes containing other ligands in addition to 8-quinolinol or its derivatives, for instance, bis(2-methyl-8-quinolinolato) (phenolato) aluminum (III), bis(2-methyl-8-quinolinolato)(o-cresolato) aluminum (III), bis(2-methyl-8-quinolinolato)(m-cresolato) aluminum (III), bis(2-methyl-8-quinolinolato)(p-cresolato) aluminum (III), bis(2-methyl-8-quinolinolato)(o-phenylphenolato)aluminum (III), bis(2-methyl-8-quinolinolato) (m-phenylphenolato)aluminum (III), bis(2-methyl-8-quinolinolato) (p-phenylphenolato)aluminum (III), bis(2-methyl-8-quinolinolato)(2,3-dimethylphenolato)aluminum (III), bis(2-methyl-8-quinolinolato)(2,6-dimethylphenolato)aluminum (III), bis(2-methyl-8-quinolinolato)(3,4-dimethylphenolato)aluminum (III), bis(2-methyl-8-quinolinolato)(3,5-dimethyl-phenolato) aluminum (III), bis(2-methyl-8-quinolinolato)(3,5-di-tert-butylphenolato)aluminum (III), bis(2-methyl-8-quinolinolato)(2,6-diphenylphenolato)aluminum (III), bis(2-methyl-8-quinolinolato)(2,4,6-triphenylphenolato)aluminum (III), bis(2-methyl-8-quinolinolato)(2,3,6-trimethyl-phenolato)aluminum (III), bis(2-methyl-8-quinolinolato) (2,3,5,6-tetramethylphenolato)aluminum (III), bis(2-methyl-8-quinolinolato)(1-naphtholato)aluminum (III), bis(2-methyl-8-quinolinolato)(2-naphtholato)aluminum (III), bis(2,4-dimethyl-8-quinolinolato)(o-phenylphenolato)aluminum (III), bis (2, 4-dimethyl-8-quinolinolato) (p-phenylphenolato)aluminum (III), bis(2,4-dimethyl-8-quinolinolato)(m-phenylphenolato) aluminum (III), bis(2,4-dimethyl-8-quinolinolato)(3,5-dimethylphenolato)aluminum (III), bis(2,4-dimethyl-8-quinolinolato) (3,5-di-tert-butylphenolato)aluminum (III), bis (2-methyl-4-ethyl-8-quinolinolato) (p-cresolato)aluminum (III), bis(2-methyl-4-methoxy-8-quinolinolato)(p-phenyl-phenolato)aluminum (III), bis(2-methyl-5-cyano-8-quinolinolato)(o-cresolato)aluminum (III), and bis(2-methyl-6-trifluoromethyl-8-quinolinolato)(2-naphtholato)aluminum (III).

Besides, use may be made of bis(2-methyl-8-quinolinol-ato)aluminum (III) -µ-oxo-bis(2-methyl-8-quinolinolato) aluminum (III), bis (2,4-dimethyl-8-quinolinolato)aluminum (III) -µ-oxo-bis(2,4-dimethyl-8-quinolinolato)aluminum (III), bis(4-ethyl-2-methyl-8-quinolinolato)aluminum (III)-µ-oxo-bis(4-ethyl-2-methyl-8-quinolinolato)aluminum (III), bis(2-methyl-4-methoxyquinolinolato)aluminum (III)-µ-oxo-bis(2-methyl-4-methoxyquinolinolato)aluminum (III), bis(5-cyano-2-methyl-8-quinolinolato)aluminum (III)-µ-oxo-bis(5-cyano-2-methyl-8-quinolinolato)aluminum (III), bis(2-methyl-5-trifluoromethyl-8-quinolinolato)aluminum (III)-µ-oxo-bis(2-methyl-5-trifluoromethyl-8-quinolinolato)aluminum (III), etc.

Other preferable host substances include phenyl-anthracene derivatives disclosed in JP-A 8-12600, tetraarylethene derivatives disclosed in JP-A 8-12969, etc.

In the practice of the invention, the light emitting layer may also serve as an electron injecting and transporting layer. In this case, it is preferable to use a fluorescent material, e.g., tris(8-quinolinolato)aluminum or the like, which may be provided by evaporation.

If necessary or preferably, the light emitting layer is formed of a mixed layer of at least one compound capable of injecting and transporting holes with at least one compound capable of injecting and transporting electrons. Preferably in this case, a dopant is incorporated in the mixed layer. The content of the dopant compound in the mixed layer is in the range of preferably 0.01 to 20% by weight, and especially 0.1 to 15% by weight.

In the mixed layer with a hopping conduction path available for carriers, each carrier migrates in the polarly prevailing substance, so making the injection of carriers having an opposite polarity unlikely to occur. This leads to an increase in the service life of the device due to less damage to the organic compound. By incorporating the aforesaid dopant in such a mixed layer, it is possible to vary the wavelength performance of light emission that the mixed layer itself possesses, thereby shifting the wavelength of light emission to a longer wavelength side and improving the intensity of light emission, and the stability of the device as well.

The compound capable of injecting and transporting holes and the compound capable of injecting and transporting electrons, both used to form the mixed layer, may be selected from compounds for the injection and transportation of holes and compounds for the injection and transportation of electrons, as will be described later. Especially for the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring.

For the compounds capable of injecting and transporting electrons, it is preferable to use metal complexes containing quinoline derivatives, especially 8-quinolinol or its derivatives as ligands, in particular, tris(8-quinolinolato) aluminum (Alq3). It is also preferable to use the aforesaid phenylanthracene derivatives, and tetraarylethene derivatives.

For the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring.

In this case, the ratio of mixing the compound capable of injecting and transporting holes with the compound capable of injecting and transporting electrons is determined while the carrier mobility and carrier density are taken into consideration. In general, however, it is preferred that the weight ratio between the compound capable of injecting and transporting holes and the compound capable of injecting and transporting electrons is of the order of 1/99 to 99/1, particularly 10/90 to 90/10, and more particularly 20/80 to 80/20.

Preferably, the thickness of the mixed layer should be equal to or greater than the thickness of a single molecular layer, and less than the thickness of the organic compound layer. More specifically, the mixed layer has a thickness of preferably 1 to 85 nm, especially 5 to 60 nm, and more especially 5 to 50 nm.

Preferably, the mixed layer is formed by co-evaporation where the selected compounds are evaporated from different evaporation sources. When the compounds to be mixed have identical or slightly different vapor pressures (evaporation temperatures), however, they may have previously been mixed together in the same evaporation boat for the subsequent evaporation. Preferably, the compounds are uniformly mixed together in the mixed layer. However, the compounds in an island archipelagic form may be present in the mixed layer. The light emitting layer may generally be formed at a given thickness by the evaporation of the organic fluorescent substance or coating a dispersion of the organic fluorescent substance in a resin binder.

For the hole injecting and transporting layer, use may be made of various organic compounds as disclosed in JP-A's 63-295695, 2-191694, 3-792, 5-234681, 5-239455, 5-299174, 7-126225, 7-126226 and 8-100172 as well as EP 0650955A1. Examples are tetraarylbenzidine compounds (triaryldiamine or triphenyldiamine (TPD)), aromatic tertiary amines, hydrazone derivatives, carbazole derivatives, triazole derivatives, imidazole derivatives, oxadiazole derivatives having an amino group, and polythiophenes. These compounds may be used alone or in combination of two or more. Where these compounds are used in combination of two or more, they may be stacked as separate layers, or otherwise mixed.

When the hole injecting and transporting layer is provided as a separate hole injecting layer and a separate hole transporting layer, two or more compounds are selected in a preferable combination from the compounds already mentioned for the hole injecting and transporting layer. In this regard, it is preferred to laminate layers in such an order that a compound layer having a lower ionization potential is disposed nearest to the hole injecting electrode (ITO, etc.). It is also preferred to use a compound having good thin film forming ability at the hole injecting electrode surface. This order of lamination holds for the provision of two or more hole injecting and transporting layers, and is effective as well for lowering driving voltage and preventing the occurrence of current leakage and the appearance and growth of dark spots. Since evaporation is utilized in the manufacture of devices, films as thin as about 1 to 10 nm can be formed in a uniform and pinhole-free state, which restrains any change in color tone of light emission and a drop of efficiency by re-absorption even if a compound having a low ionization potential and absorption in the visible range is used in the hole injecting layer. Like the light emitting layer and so on, the hole injecting and transporting layer or layers may be formed by evaporating the aforesaid compounds.

For the electron injecting and transporting layer that is preferably provided, there may be used quinoline derivatives such as organic metal complexes containing 8-quinolinol or its derivatives as ligands, for instance, tris(8-quinolinolato)aluminum (Alq3), oxadiazole derivatives, perylene derivatives, pyridine derivatives, pyrimidine derivatives, quinoxaline derivative, diphenylquinone derivatives, and nitro-substituted fluorene derivatives. The electron injecting and transporting layer may also serve as a light emitting layer. In this case, it is preferable to use tris(8-quinolilato)aluminum, etc. As is the case with the light emitting layer, the electron injecting and transporting layer may then be formed by evaporation or the like.

Where the electron injecting and transporting layer is a double-layered structure comprising an electron injecting layer and an electron transporting layer, two or more compounds are selected in a preferably combination from the compounds commonly used for electron injecting and transporting layers. In this regard, it is preferred to laminate layers in such an order that a compound layer having a greater electron affinity is disposed nearest to the electron injecting electrode. This order of lamination also applies where a plurality of electron injecting and transporting layers are provided.

To form the hole injecting and transporting layer, the light emitting layer and the electron injecting and transporting layer, it is preferable to use a vacuum evaporation technique which enables a homogeneous thin film to be obtained. According to the vacuum evaporation process, it is possible to obtain homogeneous thin films in an amorphous state or with a crystal grain diameter of at most 0.2 µm. The use of a thin film having a crystal grain diameter exceeding 0.2 µm results in non-uniform light emission. To avoid this, it is required to increase the driving voltage of the device; however, there is a striking drop of hole injection efficiency.

No particular limitation is imposed on vacuum evaporation conditions. However, an evaporation rate of the order of 0.01 to 1 nm/sec. is preferably applied at a degree of vacuum of 10⁻⁴ Pa or lower. It is also preferable to form the layers continuously in vacuum. If the layers are continuously formed in vacuum, high properties are then obtained because the adsorption of impurities on the interface between the adjacent layers can be avoided. Furthermore, the driving voltage of the device can be lowered while the occurrence and growth of dark spots are inhibited.

When the vacuum evaporation process is used to form the layers, each containing a plurality of compounds, it is preferable to carry out co-evaporation while boats charged with the compounds are individually placed under temperature control.

For the substrate on which an organic EL structure is formed according to the present invention, amorphous substrates such as glass and quartz substrates, and crystal substrates made up of Si, GaAs, ZnSe, ZnS, GaP or InP may be used. These crystal substrates may be provided thereon with a crystalline or non-crystalline metal buffer layer. For the metal substrate, Mo, Al, Pt, Ir, Au, Pd, etc. may be used. However, preference is given to a glass substrate. The substrate, when it is located on the side out of which light is taken out, should preferably be transparent to ligth as is the case with the aforesaid electrode.

Preferably, the device is sealed up by means of a sealing sheet, etc. for the purpose of preventing oxidation of the organic layers and electrodes in the device. To prevent penetration of moisture, the sealing sheet is bonded to the device using an adhesive resin layer to seal up the device. An inert gas such as Ar, He, and N₂ is preferably used as a sealing gas. Then, the sealing gas should preferably have a moisture content of up to 100 ppm, especially up to 10 ppm, and more especially up to 1 ppm. Although there is no particular lower limit to the moisture content, the sealing gas should usually have a moisture content of about 0.1 ppm.

The sealing sheet, preferably in a flat sheet form, may be made of transparent or translucent materials such as glasses, quartz, and resins, among which the glasses are preferred. For such glass materials, alkali glass is preferable from a cost standpoint. Other preferable glass materials, for instance, include soda lime glass, lead alkali glass, borosilicate glass, aluminosilicate glass, and silica glass. In particular, a soda glass material subjected to no surface treatment is inexpensive and so is preferable. A metal sheet, a plastic sheet, etc., too, may be used in place of the sealing glass sheet.

For height control, a spacer is used to keep the sealing sheet at a height as desired. The spacer material may be resin beads, silica beads, glass beads, glass fibers, etc., with the glass beads being most preferred. The spacer may or may not be used when a recess is provided in the sealing sheet.

The spacer may have been incorporated in the sealing adhesive agent or may be incorporated in the sealing adhesive agent at the time of bonding. The content of the spacer in the sealing adhesive agent should be preferably 0.01 to 30 wt%, and more preferably 0.1 to 5 wt%.

For the adhesive agent, it is preferable to use a cation curing epoxy resin of the ultraviolet curing type, although an adhesive agent of the type that ensures stable adhesion strength and good airtightness may be used.

A color filter film or a fluorescent materialcontaining color conversion film or a dielectric reflecting film may be used together with the substrate for control of emitted colors.

For the color filter film, a color filter employed with liquid crystal display devices may be used. However, it is preferable to control the properties of the color filter in conformity to the light emitted from the organic EL device, thereby optimizing the efficiency of taking out light emission and color purity.

By using a color filter capable of cutting off extraneous light of such short wavelength as absorbed by the EL device material or the fluorescent conversion layer, it is possible to improve the light resistance of the device and the contrast of what is displayed on the device.

Instead of the color filter, an optical thin film such as a dielectric multilayer film may be used.

The fluorescent color conversion film absorbs light emitted from an EL device and gives out light from the phosphors contained therein for the color conversion of light emission, and is composed of three components, a binder, a fluorescent material and a light absorbing material.

In the practice of the invention, it is basically preferable to use a fluorescent material having high fluorescent quantum efficiency, and especially a fluorescent material having strong absorption in an EL light emission wavelength region. Laser dyes are suitable for the practice of the invention. To this end, for instance, it is preferable to use rohodamine compounds, perylene compounds, cyanine compounds, phthalocyanine compounds (including subphthalocyanine compounds, etc.), naphthaloimide compounds, fused cyclic hydrocarbon compounds, fused heterocyclic compounds, styryl compounds, and coumarin compounds.

For the binder, it is basically preferable to make an appropriate selection from materials that do not extinguish fluorescence. It is particularly preferable to use a material that can be finely patterned by photolithography, printing or the like. It is also preferable to use a material that is not damaged during hole injecting electrode (e.g., ITO or IZO) film formation.

The light absorbing material is used when light is not fully absorbed by the fluorescent material, and so may be dispensed with, if not required. For the light absorbing material, it is preferable to make a selection from materials that do not extinguish the fluorescence of the fluorescent material.

The organic EL display device of the present invention is generally of the DC or pulse drive type while it may be of the AC drive type. The applied voltage is generally of the order of 2 to 30 volts.

### EXAMPLE

The present invention is explained more specifically with reference to some illustrative examples.

### Example 1

A glass substrate was provided thereon with a 100-nm thick ITO transparent electrode, and stripes of 280 µm in width and 24 mm in length were patterned on the ITO transparent electrode at an interval of 20 µm and according to an array of 256 lines. Then, a barrier metal layer or Ti-N layer and a metal electrode layer or Ag-Pd (Pd: 2.5% by weight) alloy layer were continuously formed to a thickness of 50 nm and a thickness of 300 nm, respectively. Then, Ti-N layers of 20 µm in width were formed on one side of the ITO transparent electrode stripes in such a way that they overlapped each other at a width of 5 µm. Then, an Ag-Pd layer of 10 µm in width was formed by patterning on the Ti-N layer, thereby forming a hole injecting electrode stripe pattern comprising an ITO transparent electrode, an Ag-Pd metal electrode formed on its one side and a Ti-N barrier metal layer interposed between them. At this time, the ITO transparent electrode, Ti-N barrier metal layer and Ag-Pd metal electrode were found to have a sheet resistance of 50 Ω/□, 40 Ω/□ and 0.13 Ω/□, respectively. The hole injecting electrode was found to have an interconnecting resistance of 300 Q per line.

Thereafter, an insulating layer was formed and patterned so as to provide insulation of an area other than light emitting areas, and openings of 260 x 260 µm² in size were formed on the insulating layer at an interval of 40 µm and according to an array of 64 dots x 256 lines, thereby forming the light emitting areas. Furthermore, a device separating structure was formed according to a given pattern at right angles with the hole injecting electrode stripes. The thus obtained substrate was ultrasonically washed with neutral detergent, warm pure water and super-pure water, and then dried by an air knife using destaticized and heated nitrogen. During the process mentioned above, no hillocks were found in the metal electrode.

Then, the substrate was cleaned on its surface with UV/O₃, and fixed to a substrate holder in a vacuum evaporation system, which was evacuated to a vacuum of 1 x 10⁻⁴ Pa or lower. M-MTDATA or N,N-diphenyl-N,N'-m-tolyl-4,4',4''-tris-(N-(3-methylphenyl)-N-phenylamino)triphenylamine was deposited by evaporation at a deposition rate of 0.2 nm/sec. to a thickness of 40 nm, thereby forming a hole injecting layer. With the vacuum still maintained, TPD or N,N'-diphenyl-N,N'-m-tolyl-4,4'-diamino-1,1'-biphenyl was then deposited by evaporation at a deposition rate of 0.2 nm/sec. to a thickness of 35 nm, thereby forming a hole transporting layer. With the vacuum still kept, Alq3 was deposited by evaporation at a deposition rate of 0.2 nm/sec. to a thickness of 50 nm, thereby forming a combined electron injecting/transporting and light emitting layer. With the vacuum still kept, MgAg was deposited by co-evaporation (binary evaporation) at an evaporation rate ratio of Mg:Ag = 10:1 to a thickness of 200 nm, thereby forming an electron injecting layer. This electron injecting electrode was isolated and insulated by the given pattern of device separating structure, so that it could be positioned at right angles with the hole injecting electrode. At sites other than the light emitting areas, the electron injecting electrode was completely insulated from the hole injecting electrode by the insulating layer formed on the hole injecting electrode.

The thus assembled organic EL device was driven in a dry air atmosphere in such a way that a luminance of 100 cd/m² was obtained. Luminance of the device from the current feed side to the opposite side was measured using the range of 7 dots x 7 lines as one measure unit. As a result, it was found that throughout the areas measured, light emission luminance variations with respect to the time-average light emission luminance of 100 cd/m² on the current feed side were within -5%. From this, it was understood that there is no considerable influence of voltage drops even on a large-area screen display.

### Comparative Example 1

An organic EL device was obtained as in Example 1 with the exception that instead of Ag-Pd, Al was used as the metal electrode. During the substrate fabrication process, hillocks were found in the Al metal electrode. From the fact that the reverse bias withstand voltage of the organic EL device was low, it was found that this comparative example was inferior in durability than Example 1.

### Comparative Example 2

An organic EL device was obtained as in Example 1 with the exception that instead of Ag-Pd, an Al-Ti (Ti: 2.5% by weight) alloy was used as the metal electrode. During the substrate fabrication process, no hillocks were found in the Al-Ti metal electrode. The Al-Ti metal electrode had a sheet resistance of 0.3 Ω/□, and the hole injecting electrode had an interconnecting resistance of 600 Ω per line. The obtained organic EL device was driven and estimated as in Example 1. As a consequence, it was found that some areas of the device showed light emission luminance variations of greater than -5% with respect to the time-average light emission luminance of 100 cd/m² on the current feed side.

### Example 2

An organic EL device was obtained as in Example 1 with the exception that any barrier metal layer was not formed at all. During the substrate fabrication process, no particular problem was found. The hole injecting electrode had an interconnecting resistance of 300 Ω per line as was the case with Example 1. The obtained organic EL device was driven and estimated as in Example 1. The results were substantially the same as in Example 1. In this example, any photomask for the barrier metal layer was not used and the step of forming the barrier metal layer was omitted. As a result, about 3% cost reductions was achieved as compared with Example 1.

### Example 3

An organic EL device was obtained as in Example 2 with the exception that instead of Ag-Pd, an Ag-In (In: 2.5% by weight) alloy was used as the metal electrode. At this time, the hole injecting electrode had an interconnecting resistance of 300 Ω per line. The obtained organic EL device was driven and estimated as in Example 2. The results were substantially the same as in Example 2.

### Example 4

An organic EL device was obtained as in Example 2 with the exception that instead of Ag-Pd, a Cu-Pd (Pd: 2.5% by weight) alloy was used as the metal electrode. At this time, the hole injecting electrode had an interconnecting resistance of 300 Ω per line. The obtained organic EL device was driven and estimated as in Example 2. The results were substantially the same as in Example 2.

### Comparative Example 3

A hole injecting electrode was prepared as in Example 1 with the exception that instead of Ag-Pd, Al was used as the metal electrode. The ITO transparent electrode could not well be joined to the Al metal electrode, and the ITO transparent electrode underwent electro-chemical corrosion due to battery reactions occurred between ITO and Al during the process. It was thus impossible to obtain a substrate for an organic EL device.

### Comparative Example 4

An organic El device was obtained as in Example 2 with the exception that no metal electrode layer was formed. At this time, the hole injecting electrode had an interconnecting resistance of 4 kΩ per line. The obtained organic EL device was driven and estimated as in Example 2. As a result, it was found that the device showed a luminance variation of a high -20% with respect to the time-average light emission luminance of 100 cd/m² on the current feed side.

### Comparative Example 5

An organic EL device was obtained as in Comparative Example 4 with the exception that the thickness of the ITO transparent electrode was changed to 1,500 nm. At this time, the ITO transparent electrode had a sheet resistance 3.3 Ω/ □, and the hole injecting electrode had an interconnecting resistance of 300 Ω per line as was the case with Example 2. The obtained organic EL device was driven and estimated as in Example 2. As a result, it was found that the spectra of the extracted light varied, and the luminance was lower than that of Example 2 when compared on the same driving current level. From the fact that the reverse bias withstand voltage of the device was low, it was also found that this comparative example was inferior in durability than Example 2. On the other hand, this device was driven for 5,000 hours. As a result, it was found that the density of dark spots observed was about 5 times as high as that in Example 2, showing reliability drops.

### Comparative Example 6

An organic EL device was obtained as in Example 2 with the exception that instead of Ag-Pd, Ag was used as the metal electrode. At this time, the ITO transparent electrode had a sheet resistance of 0.08 Ω/□, and the hole injecting electrode had an interconnecting resistance of 200 Ω per line, which figure was lower than that in Example 2. The obtained organic EL device was driven and estimated as in Example 2. As a result, it was found that throughout the areas measured in the initial stage, light emission luminance variations with respect to the time-average light emission luminance of 100 cd/m² on the current feed side were all within -4%. After the lapse of 5,000 hours, however, a luminance change of -10% at most was observed.

### Example 5

An organic EL device was obtained as in Example 2 with the exception that instead of Ag-Pd, an Ag-Pd-Cu (Pd: 2.5% by weight - Cu: 2.5% by weight) alloy was used as the metal electrode. At this time, the hole injecting electrode had an interconnecting resistance of 300 Ω per line. The obtained organic EL device was driven and estimated as in Example 2. The results were much the same as in Example 2. It was also found that a margin wider than in Example 2 could be obtained to set up process conditions concerning the baking temperature, developer concentration, etching solution concentration, etc. for the fabrication of the substrate for this device.

### Example 6

An organic EL device was obtained as in Example 2 with the exception that instead of Ag-Pd, an Ag-Pd-Ti (Pd: 2.5% by weight - Ti: 2.5% by weight) alloy was used as the metal electrode. At this time, the hole injecting electrode had an interconnecting resistance of 300 Ω per line. The obtained organic EL device was driven and estimated as in Example 2. The results were much the same as in Example 2. It was also found that a margin wider than in Example 2 could be obtained to set up process conditions concerning the baking temperature, developer concentration, etching solution concentration, etc. for the fabrication of the substrate for this device.

### Example 7

An organic EL device was obtained as in Example 2 with the exception that instead of Ag-Pd, an Ag-Pd-Cr (Pd: 2.5% by weight - Cr: 2.5% by weight) alloy was used as the metal electrode. At this time, the hole injecting electrode had an interconnecting resistance of 300 Ω per line. The obtained organic EL device was driven and estimated as in Example 2. The results were much the same as in Example 2. It was also found that a margin wider than in Example 2 could be obtained to set up process conditions concerning the baking temperature, developer concentration, etching solution concentration, etc. for the fabrication of the substrate for this device.

### Example 8

An organic EL device was obtained as in Example 5 with the exception that the composition ratio of the metal electrode Ag-Pd-Cu was changed to Pd = 1.25% by weight - Cu = 1.25% by weight. At this time, the hole injecting electrode had an interconnecting resistance of 300 Ω per line. The obtained organic EL device was driven and estimated as in Example 5. The results were much the same as in Example 5. It was also found that in Example 5, too, a wider margin could be obtained to set up process conditions concerning the baking temperature, developer concentration, etching solution concentration, etc. for the fabrication of the substrate for this device.

### Example 9

An organic EL device was obtained as in Example 8 with the exception that the thickness of the ITO transparent electrode was changed to 150 nm. The obtained organic EL device was driven and estimated as in Example 8. The results were much the same as in Example 8.

### Example 10

An organic EL device was obtained as in Example 8 with the exception that the thickness of the ITO transparent electrode was changed to 50 nm. The obtained organic EL device was driven and estimated as in Example 8. The results were much the same as in Example 8. At this time, the hole injecting electrode had an interconnecting resistance of 300 Ω per line as was the case with Example 8. After the device had been driven for 5,000 hours, it was found that the density of dark spots measured was 1/2 or less of that in Example 8; some considerable improvements were obtained in reliability.

### Example 11

An organic EL device was obtained as in Example 8 with the exception that an IZO transparent electrode was used as the transparent electrode. The obtained organic EL device was driven and estimated as in Example 8. The results were much the same as in Example 8.

### Example 12

Example 3 was repeated with proviso that Rh, Pt, and Au was used in place of In. In any case, the results were much the same as in Example 3.

### Example 13

Example 6 was repeated with proviso that V, Mn, Fe, Co, Ni, Nb, Mo, Ta, and W was used in place of Ti. In any case, the results were much the same as in Example 6.

### ADVANTAGES OF THE INVENTION

According to the present invention, it is possible to achieve a high-quality yet low-cost organic EL display device by lowering the wiring resistance of a transparent electrode, improving the dependence of extracted spectra on the angle of field, stabilizing a fabrication process due to prevention of hillocks, and dispensing with any barrier metal layer, thereby achieving considerable cost reductions.

While the invention has been described with reference to preferred embodiments, it will be obvious to those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed as the best mode contemplated for carrying out the invention, but that the invention will include all embodiments falling within the scope of the appended claims.

## Claims

1. An organic EL display device comprising a pair of electrodes and at least one organic layer interposed between the electrodes, wherein:
at least one of said electrodes comprises an indium oxide-containing transparent electrode at a site corresponding to a light emitting area, and
a metal electrode is provided at a site other than said site corresponding to said light emitting area, where said metal electrode is connected to said transparent electrode,
said metal electrode containing as a main component Ag, Cu or Ag-Cu and as a subordinate component one or two or more metal elements selected from the group consisting of at least Rh, Pd, In, Pt and Au.

2. The organic EL display device according to claim 1, wherein said transparent electrode is directly connected to said metal electrode.

3. The organic EL display device according to claim 1 or 2, wherein said subordinate component accounts for 0.1 to 5% by weight of all components.

4. The organic EL display device according to any one of claims 1 to 3, wherein said transparent electrode has a film thickness of 100 nm or less.

5. The organic EL display device according to any one of claims 1 to 4,wherein said metal electrode further contains one or two or more metal elements selected from the group consisting of Ti, V, Cr, Mn, Fe, Co, Ni, Nb, Mo, Ta and W in an amount of 0.1 to 5% by weight with respect to all components.

6. The organic EL display device according to any one of claims 1 to 5, wherein said main component is an alloy comprising Ag and Cu as primary ingredients.

7. The organic EL display device according to any one of claims 1 to 6, wherein said main component is an alloy comprising Ag and Cu as primary ingredients with the content of Cu in said main component being 0.1 to 5% by weight with respect to all ingredients, and
said main component contains as an additional subordinate component Pd in an amount of 0.1 to 5% by weight to all components.
